(19) **Europäisches Patentamt / European Patent Office / Office européen des brevets**

(11) **EP 1 729 435 B1**

(12) **EUROPEAN PATENT SPECIFICATION**

(45) Date of publication and mention
of the grant of the patent:
**27.02.2008 Bulletin 2008/09**

(51) Int Cl.:
*H04L 1/06* (2006.01)  *H04L 1/00* (2006.01)

(21) Application number: **05011865.2**

(22) Date of filing: **01.06.2005**

(54) **Communication relay apparatus**

Kommunikationsrelaiseinrichtung

Dispositif de relais de communication

(84) Designated Contracting States:
**DE FR GB**

(43) Date of publication of application:
**06.12.2006 Bulletin 2006/49**

(73) Proprietor: **NTT DoCoMo, Inc.**
**Tokyo (JP)**

(72) Inventors:
• **Hausl, Christoph**
**80798 München (DE)**
• **Schreckenbach, Frank**
**80335 München (DE)**
• **Oikonomidis, Ioannis**
**80797 München (DE)**
• **Bauch, Gerhard**
**80799 München (DE)**

(74) Representative: **Schoppe, Fritz et al**
**Patentanwälte**
**Schoppe, Zimmermann, Stöckeler & Zinkler**
**Postfach 246**
**82043 Pullach bei München (DE)**

(56) References cited:
**WO-A-20/05027396**

• **ZIMMERMANN E ET AL: "On the performance of cooperative diversity protocols in practical wireless systems" VEHICULAR TECHNOLOGY CONFERENCE, 2003. VTC 2003-FALL. 2003 IEEE 58TH ORLANDO, FL, USA 6-9 OCT. 2003, PISCATAWAY, NJ, USA,IEEE, US, vol. 4, 6 October 2003 (2003-10-06), pages 2212-2216, XP010701645 ISBN: 0-7803-7954-3**
• **BIN ZHAO ET AL: "Practical relay networks: a generalization of hybrid-ARQ" IEEE Journal on Selected Areas in Communications IEEE USA, vol. 23, no. 1, January 2005 (2005-01), pages 7-18, XP002350613 New York, US ISSN: 0733-8716**
• **YANG CAO ET AL: "Cooperative coding using serial concatenated convolutional codes" WIRELESS COMMUNICATIONS AND NETWORKING CONFERENCE, 2005 IEEE NEW ORLEANS, LA, USA 13-17 MARCH 2005, PISCATAWAY, NJ, USA,IEEE, 13 March 2005 (2005-03-13), pages 1001-1006, XP010791308 ISBN: 0-7803-8966-2**
• **WITTNEBEN A ET AL: "Joint cooperative diversity and scheduling in low mobility wireless networks" GLOBAL TELECOMMUNICATIONS CONFERENCE, 2004. GLOBECOM '04. IEEE DALLAS, TX, USA 29 NOV.-3 DEC., 2004, PISCATAWAY, NJ, USA,IEEE, vol. 2, 29 November 2004 (2004-11-29), pages 780-784, XP010757635 ISBN: 0-7803-8794-5**

## Description

The present invention relates to digital communication systems, and more particularly to digital communication networks.

A digital communication network consists of one or several sources, intermediate nodes (relays) and one or several sinks. Information has to be transmitted from the source(s) to the sink(s) over the network whereas the nodes are often connected by band-limited channels with time-varying disturbance. The technical aim is to provide a high quality communication with low bit error rate whereas the total transmission power is restricted.

A known solution to transmit data from a source to a sink over a network is to route the information through the network. To protect the information against errors, the source channel-encodes the information, the relay tries to reconstruct the information with a channel decoder, channel-encodes the information again and sends it to the next relay or to the sink. The sink tries to reconstruct the information by considering all the information which was sent to the sink. In B Zhao and M. Valenti, "Distributed Turbo Coded Diversity for the Rayleigh Channel", Electronic Letters, 39: 786 - 787, 2003, it was shown how a distributed turbo code can be used in a system with one source, one relay and one sink. Turbo codes are iterative channel codes which provide a much better performance than non-iterative channel coding schemes.

Moreover, in B. Zhao and M. Valenti, "Practical Relay Networks: A Generalization of Hybrid-ARQ", IEEE Journal on Selected Areas in Communications, 23(1):7-18, January 2005, a generalization of the hybrid-automatic repeat request (ARQ) protocol was presented for relay networks which enables a more practical and more flexible use of relays.

According to this protocol the source sends channel coded information to the sink. The relays listen to this transmission as well. If a relay is able to decode the information of the source, then it could send additional redundancy to the sink. In the contention period, it is decided, if one of these relays or the source sends the next block with additional redundancy, where the relays and the source inform each other if they have decoded successfully.

However, the known solutions only provide sub-optimal possibility to transmit data with respect to a used power allocation, bandwidth and bit error rate.

Furthermore, iterative decoding of low-density parity-check (LDPC) codes is a powerful method for approaching capacity or AWGN channels (AWGN = additive Gaussian white noise) as it was shown in T. J. Richardson, M. A. Shokrollahi and R. L. Urbanke, "Design of Capacity-Approaching irregular low density parity-check codes", IEEE Transactions on Information Theory, 47(2):619-637, February 2001.

Document WO 2005/027396 A1 discloses a method and system for transmitting signals in a wireless relay network. The method and system enable two potentials, which can be offered by wireless relay systems, i.e. diversity gains and attenuation savings, to be exploited simultaneously. The method disclosed in WO 2005/027396 A1 is characterized in that a relay mounted between the source and the destination decides, independently from information relating to other components of the network, whether a signal received from the source or from at least one other relay is to be decoded and forwarded. The system is characterized in that the relay comprises a decision unit for signal decoding and forwarding decision.

Thus, it is the object of the present invention to provide a possibility for a data transmission having improved characteristics.

This object is achieved by a communication relay apparatus according to claim 1, a communication relay system according to claim 9, a method for providing a network-encoded information unit sequence according to claim 10, a communication receiver according to claim 11, a communication receiver system according to claim 20 and a method for providing a first and second channel decoder output sequence according to claim 21.

The present invention provides a communication relay apparatus for providing a network-encoded information unit sequence, the communication relay apparatus comprising:

a first channel decoder being configured to supervise a first wireless channel, to receive a first channel-encoded sequence of information units from a first data source via the first wireless channel and to decode the first channel-encoded sequence of information units to obtain a first decoded sequence of information units;

a second channel decoder being configured to supervise a second wireless channel, to receive a second channel-encoded sequence of information units from a second data source via the second wireless channel and to decode the second channel-encoded sequence of information units to obtain a second decoded sequence of information units, the first and second wireless channels being different from each other; and

a network encoder being configured to network-encode information of the first and second decoded sequences of information units into the network-encoded information unit sequence, wherein the network encoder is further configured to wirelessly transmit the network-encoded information unit sequence to a data sink.

Furthermore, the present invention provides a method for providing a network-encoded information unit sequence comprising the steps of:

receiving a first channel-encoded sequence of information units from a first data source via a first wireless channel and to decode the first channel-encoded sequence of information units to obtain a first decoded sequence of information units;

receiving a second channel-encoded sequence of information units from a second data source via a second wireless channel and to decode the second channel-encoded sequence of information units to obtain a second decoded sequence of information units, the first and second wireless channels being different from each other;

network-encoding information of the first and second decoded sequences of information units into the network-encoded information unit sequence; and

wirelessly transmit the network-encoded information unit sequence to a data sink.

Additionally, the present invention provides a communication receiver for providing a first and a second channel decoder output sequence, the communication receiver comprising:

a network decoder being configured to receive a network-encoded sequence of information units, the network-encoded sequence of information units comprising information of a first and a second data source that has been transmitted on a first and a second wireless, channel respectively, wherein the network decoder is configured to decode the network-encoded sequence of information units into a network decoder sequence;

a first channel decoder being configured to receive a first channel-encoded sequence of information units from a first data source via a first channel and to decode the first channel-encoded sequence of information units using the network decoder sequence to obtain the first channel decoder output sequence; and

a second channel decoder being configured to receive a second channel-encoded sequence of information units from a second data source via a second channel, the first and second channels being different from each other, wherein the second channel decoder is further configured to decode the second channel-encoded sequence of information units using the network decoder sequence to obtain the second channel decoder output sequence.

Moreover, the present invention provides a method for providing a first and a second channel decoder output sequence comprising the steps of:

receiving a network-encoded sequence of information units with a network decoder, the network-encoded sequence of information units comprising information of a first and second data source;

decoding the network-encoded sequence of information units into a network decoder sequence;

receiving a first channel-encoded sequence of information units from a first data source with a first channel decoder via a first channel;

decoding the first channel-encoded sequence of information units with the first channel decoder using the network decoder sequence to obtain the first channel decoder output sequence;

receiving a second channel-encoded sequence of information units from a second data source with a second channel decoder via a second channel, the first and second channels being different from each other;

decoding the second channel-encoded sequence of information units with the second channel decoder using the network decoder sequence to obtain the second channel decoder output sequence.

The present invention is based on the finding that an improvement in transmission characteristics can be realized if a communication relay for the transmission of data from two data sources to one data sink is used, in which the information of the two data sources, for example the information of two mobile stations, are combined in a network-coded signal. In this system design, the relay receives the channel-encoded data of two data sources and channel decodes it. Then the received data of the two data sources is combined into one network-(channel-)encoded data stream in which the data of the two data sources is identified, for example, by a special signature or header. Preferably, by the use of a special code in this network-encoding operation, this network-encoded data stream is furthermore also channel-encoded. After the network-encoding operation, the network-encoded data is transmitted to the data sink in which a network-decoding operation can be carried out such that the (decoded) information of the two data sources can additionally be used to decode the information which is directly received from the two data sources.

The present invention provides the advantage that the new solution allows to transmit data with a lower bit error rate when the same transmission power and the same bandwidth is used. Alternatively, less transmission power or bandwidth is necessary to obtain the same quality of service or a higher data throughput can be achieved with the same bandwidth.

Especially, if a rate-compatible network-channel code and an (extended) generalized hybrid-ARQ protocol is used, a decentralized relay organization is possible. This has the following advantages:

1. Optional use of a relay. This is important because in wireless system a relay will not be always available.

2. No additional requirements at the sources. That means the sources have not to know if a relay is available.

3. The sink (e.g. the base station in a cellular based mobile communication system) has not to organize the relay transmission.

The inventive approach has the advantage that no contention period is necessary. This enables are more efficient protocol.

Thus, the inventive approach allows to organize networks more economically. This applies especially for cellular based mobile communication systems with relay transmission. Especially, with the combination of network coding and iterative decoding, bandwidth can be saved and less transmission power is necessary. This saves costs, especially in wireless applications, where bandwidth is rare and expensive. Moreover, battery life can be saved at the transmitter. This is an important economic advantage in mobile communication systems.

The extension and the adaption of the generalized hybrid-ARQ protocol for systems which use iterative network and channel decoding allows a more practical involvement and in ad-hoc networks. Thus, the involvement of relays is brought closer to possible applications. The use of relays in cellular based mobile communication systems achieves lower costs for the infrastructure, because relays allow an enlargement of the cells. Therefore, less cells and base stations are necessary to cover a certain area.

Embodiments of the present invention are described in more detail with respect to the enclosed figures, wherein

Fig. 1    shows a schematic diagram of the use of the present invention;

Fig. 2    shows a block diagram of a first embodiment of the present invention;

Fig. 3    shows diagrams of Tanner graphs for decoding according to the embodiment of the present invention as shown in Fig. 2;

Fig. 4    shows an embodiment of the inventive communication receiver;

Fig. 5    shows a table of a special combination of variables for use of the disclosed embodiments of the present invention;

Fig. 6    shows a diagram in which a comparison of the bit error rates of several system designs, including an embodiment of the present invention, is disclosed;

Fig. 7    shows a diagram in which a comparison of the frame error rates of several system designs, including an embodiment of the present invention, is disclosed; and

Fig. 8    shows system designs in which one relay serves for transmission of data from more than two data sources and in which one data source uses more than one relay.

Equal or similar elements are denoted with equal or similar reference signs, wherein a repetition of the explanation of these elements is omitted.

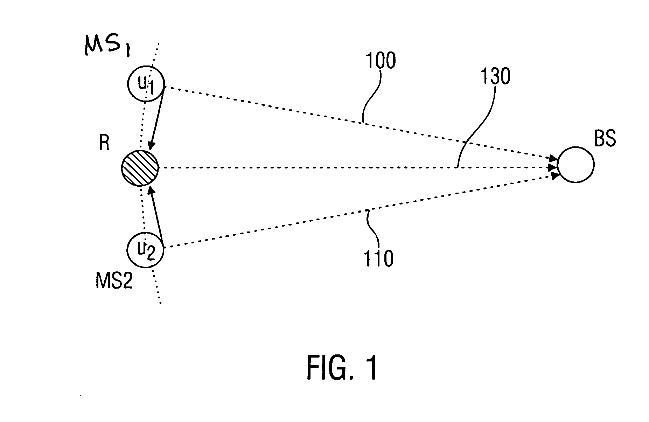

In a network with two sources, one relay and one sink (e.g. uplink in a cellular based mobile communication system as shown in Fig. 1) the two sources (for example users) MS1 and MS2 want to transmit statistically independent data which are segmented in blocks $u_1$ and $u_2$ with the block length K to the sink (base station) BS. In order to support the transmission, even in the case of a weak first channel 100 or a weak channel 110, a relay R is used which is provided with data from a first source MS1 and a second source MS2. The relay R can then transmit the information received from the first and second sources MS1 and MS2 via the relay channel 130 to the sink BS.

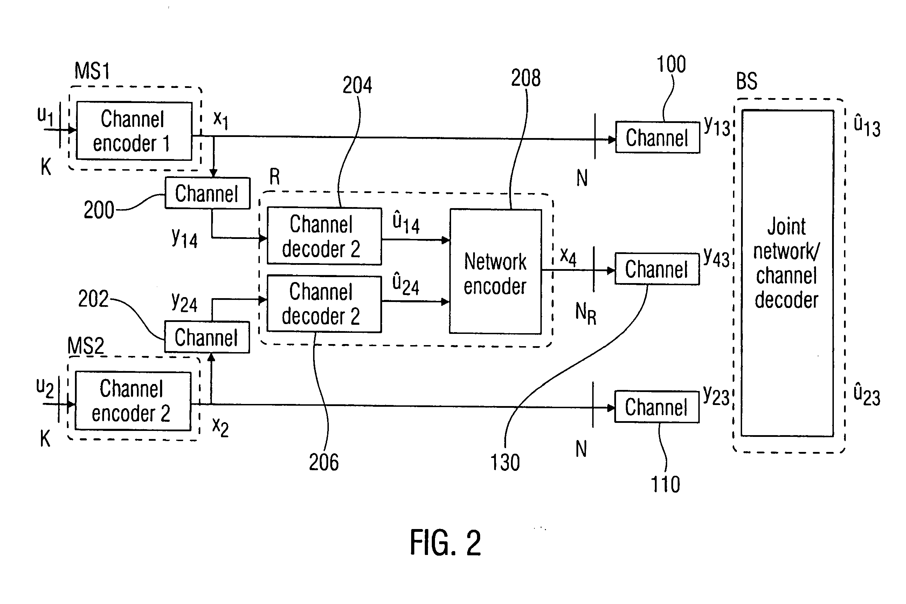

A block diagram of an embodiment of the inventive approach is depicted in Fig. 2. The information units (e.g. bits) $u_1$ and $u_2$ are protected against transmission errors with channel encoders which output channel-encoded information unit sequence $x_1$ (i.e. channel encoder 1 in MS1) and $x_2$ (i.e. channel encoder 2 in MS2) with the block length N. The relay R, which receives, due to the transmission via the channel 200 and 202, the distributed versions of the channel-encoded information unit sequence $x_1$ (i.e. $y_{14}$) and $x_2$ (i.e. $y_{24}$) can decode the received sequences and should provide additional error protection by using linear network coding. This means that the relay receives the information $y_{14}$ from the first source MS1 and decodes it in the first channel decoder 1 204 to obtain the first estimate $\hat{u}_{14}$ wherein the relay receives the information $y_{24}$ from the second source MS2 and decodes it in the second channel decoder 2 206 in order to obtain the second estimate $\hat{u}_{24}$. The both estimates $\hat{u}_{14}$ and $\hat{u}_{24}$ are linearly jointly combined to the network-encoded information units (e.g. bits) $x_4$ which have the block length $N_R$. This joint network-encoding operation is carried out in the network encoder 208 as shown in Fig. 2. Herein, the network encoder 208 can use a network code for combining the information of the first and second data sources into one data stream. This combined data stream can be channel encoded by the choice of a special network-channel code (e.g. a LDPC = low-density parity-check code) in order to provide an improved protection when the network-encoded data stream is transmitted via the channel 130 linking the communication relay apparatus R with the data sink (base station BS). Nevertheless, the output data stream $x_4$ of the communication relay apparatus R is denoted in the present description only as "network-encoded" sequence of information units $x_4$ as the main feature of this sequence is that it comprises the information of both, the first and second data sources which are derived from the estimates $\hat{u}_{14}$ and $\hat{u}_{24}$. In the sink BS (base station) a joint network/channel decoder can be configured such, that it provides a first output information sequence $\hat{u}_{13}$ and a second output information sequence $\hat{u}_{23}$ wherein the first information output sequence is assumed to comprise data send from the first source and wherein the second output information sequence is assumed to comprise data sent from the second source. The exact way for deriving the first and second output information sequences from the information sequences, the sink receives from the first and second sources and the relay is discussed in more detail below.

Further, the channel model used in this example is discussed in more detail. Here, the case of a general AWGN fading channel is considered which can be described by

$$y_{i3} = a_i \cdot x_i + n_i,$$

for $i \in \{1, 2, 4\}$ where the noise is $n_i$ is zero mean and Gaussian with variance $\sigma^2$ and the elements of the code blocks $x_i$ are either -1 or +1. The channel factor $a_i$, which is constrained by $E[a_i^2] = 1$, is Rayleigh distributed and represents the fading due to multipath propagation and the motion of the transmitter. The fading factors $a_i$ ($i \in \{1, 2, 4\}$) of the three channels are assumed to be statistically independent and constant over one block.

As fading only appears at the channel from the relay R to the base station BS, if the relay is mobile (e.g. another user is the relay), a second model for this channel is also considered. If the relay is stationary (e.g. installed at a traffic light) this channel is assumed to be an additive white Gaussian noise (AWGN) channel without fading ($a_4 = 1$).

Further, channel and network coding is referred to in more detail. An LDPC code, as already mentioned in the introductory portion, can be either characterized through the parity check matrix **H** or the corresponding Tanner graph. In this section, it is shown that the Tanner graph provides a framework to describe the channel code and the network code and allows to decode them jointly.

First, channel coding is dealt with. Linear block codes (e.g. LDPC codes) are used for the channel coding at MS1 and MS2 in this embodiment of the present invention. The two LDPC codes with rate R = K/N are linear block codes specified by sparse parity-check matrices $H_i$ ($i \in \{1, 2\}$) with N columns and N - K rows. The Tanner graph of an LDPC code consists of N variable nodes on one side and N - K check nodes on the other side, as explained in more detail below. Each variable node represents for example a code bit, each check node for example a parity check equation which corresponds to one row of $H_i$. The code bits $\mathbf{x}_i = \mathbf{u}_i\mathbf{G}_i$ ($i \in \{1, 2\}$) are generated from the information bits by multiplication with the generator matrix $\mathbf{G}_i$, which has to fulfill the condition $\mathbf{G}_i\mathbf{H}_i^T = \mathbf{0}$.

Further, network coding is dealt with in more detail. The network encoder linearly combines the decoded information bits $\hat{u}_{14} = \mathbf{u}_i$ and $\hat{u}_{24} = \mathbf{u}_2$, which are assumed to be recovered correctly, to calculate the network code bits

$$\mathbf{x}_4 = \mathbf{u}_1\mathbf{G}_{41} + \mathbf{u}_2\mathbf{G}_{42} = [\mathbf{u}_1 \quad \mathbf{u}_2]\,\mathbf{G}_4.$$

Herein, **G** denotes the generator matrix of the network encoder 208 at the relay R. The network code, which has the rate $R_R = (2 \cdot K)/N_R$, provides $N_R$ additional parity-check equations which can support the decoding at the sink BS (base station). In contrast to the channel codes the network code combines the information bits of MS1 and MS2. Therefore, the encoding operations at MS1, MS2 and the relay can be described jointly:

$$x = \begin{bmatrix} x_1 & x_2 & x_3 \end{bmatrix} = \begin{bmatrix} u_1 & u_2 \end{bmatrix} \begin{bmatrix} G_1 & 0 & G_{41} \\ 0 & G_2 & G_{42} \end{bmatrix} = uG$$

Although the different coding operations are processed spatially distributed, they will be treated them as one network-channel code with the system rate

$$R_S = \frac{2 \cdot K}{2 \cdot N + N_R} = \frac{1}{\dfrac{1}{R} + \dfrac{1}{R_R}}$$

The parity-check matrix H of the network-channel code has to fulfill $\mathbf{GH}^T = \mathbf{0}$ and contains $2 \cdot (N-K)+N_R$ rows and $2 \cdot N+N_R$ columns. The decoder at the sink BS (base station) can process the message-passing algorithm on the Tanner graph which corresponds to the parity-check matrix **H** of the network-channel code and thus, exploit the diversity provided by the network coding scheme.

Further, the network-channel code construction is focussed in more detail. Here, it has to be considered how to construct the network-channel code as an LDPC code for example, whereas this will be done for the complete network-channel code in one step, even if the encoders are spatially distributed. The rate of the network-channel code is given by $R_S = 1 - d_V/d_C$, where dv is the average degree of the variable nodes and $d_C$ is the average degree of the check nodes. Due to the distributed network-channel encoding, parity check equations belonging to a channel code are only allowed to contain code bits of the same channel code, whereas there are no restrictions for the parity-check equations of the network code. Keeping these constraints, we can use an arbitrary linear block code as network-channel code.

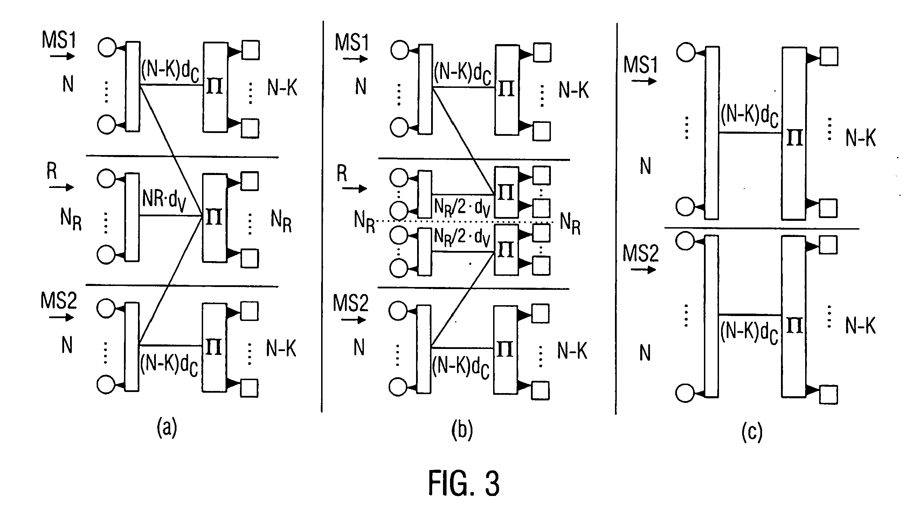

The structure of the Tanner graph corresponding to the network-channel code is depicted in Fig. 3(a). The circles depict the variable nodes and the squares the check nodes. The graph consists of three parts for the two channel codes (upper and lower part) and the network code (middle part). Each part gets the information which initialises the message-passing algorithm from a different channel, whose fading factors are statistically independent. As the network code combines information of the first source MS1 and the second source MS2, its check nodes connect variable nodes of all three code parts and thus, the received information of all channels can be used to decode the information bits of one source (user). This allows to exploit the diversity provided by the three independent fading channels. For example, if the transmission from the first source MS1 to the sink BS (base station) has very strong fading ($a_1 = 0$) it could be possible to reconstruct the information bits of the first source MS1 only from the received information from the second source MS2 and the information received from the relay.

Moreover, network coding is combined with channel coding. As the performance of LDPC codes depends strongly on the block length, the joint decoding of the network and the channel code has the advantage that the Tanner graph which is used for decoding has a larger block length, as the information of the two sources (users) is jointly decoded. This positive effect could be used for AWGN channels as well and would be even more significant, if network coding would be applied to the information of more than two sources (users).

As the network code connects and combines the two channel codes the diversity provided by network coding can be exploited in Fig 3(a). In Figure 3(b) a structure of the Tanner graph of a first reference system with relay but without network coding is disclosed. Herein, the information originating from the first and second sources MS1 and MS2 are not combined in a joint network-encoded information unit sequence as realized in the present invention. Therefore, Fig. 3(b) only shows two separated paths for the respective information transmitted via the relay channel. In Fig. 3(c) a structure of the Tanner graph of a second reference system without a relay is disclosed. Herein, only the transmission over the first and second channel from the first and second sources to the sink (base station) are shown. To get a fair comparison the sum of the code bits in the system $2N + N_R$ stays constant.

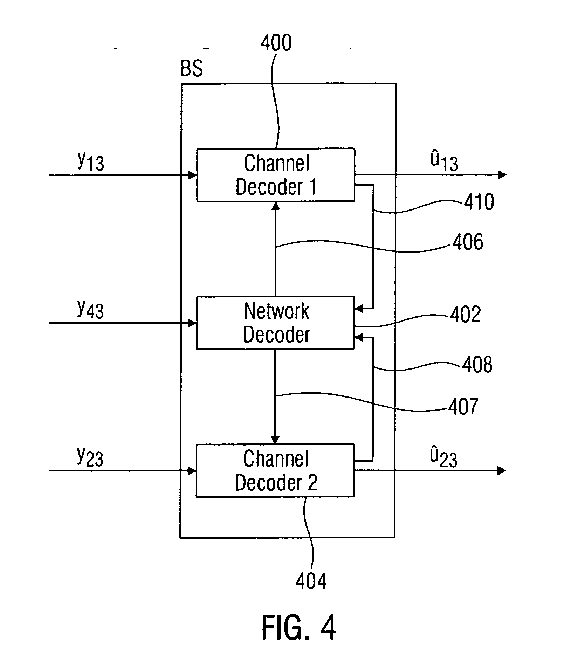

Fig. 4 shows a more detailed block diagram of the sink which is assumed to be a base station BS working as a communication receiver. The base station BS comprises a first channel decoder 300, a network decoder 402 and a second channel decoder 404. The first channel decoder 400 is configured to receive a fist channel-encoded information unit sequence $y_{13}$ via a channel 100 from a first data source MS1 as can be seen from Fig. 2. The network decoder 402 is configured to receive the network-encoded sequence of information units $y_{43}$ via a channel 130 from the communication relay apparatus R as shown in Fig. 2. The second channel decoder 404 is configured to receive the second channel-encoded information unit sequence $y_{23}$ via a second channel 110 from the second data source MS2 as also shown in Fig. 2. Channel decoder 1 and 2 (400 and 404) deliver estimated (soft) information about $u_1$ and $u_2$ to the network decoder 402 via the path 410 and the path 408. As the network-encoded sequence of information units comprises information originating from the first and second data sources MS1 and MS2, which is included in the network-encoded sequence of information units, the network decoder 402 is configured to calculate a network decoder sequences 406 and 407 which is provided to the first channel decoder 400 and the second channel decoder 404 where the (soft) information which the network decoder receives via path 410 and 408 has to be used. Furthermore, the network decoder 402 is configured to carry out a network-decoding algorithm in order to separate the information which originates from the first data source from the information which originates from the second data source. Thus, the network decoder provides for both of the channel decoders an additional amount of (soft) information which can be used in the both channel decoders 400 and 404 to reconstruct the received channel-encoded sequence of information units such that the first channel decoder 400 can output the first channel decoder output sequence $\hat{u}_{13}$ which, in the optimal case, is exactly the information sequence $u_1$ which is to be transmitted by the first data source MS1 (as shown in Fig. 2). Same applies also for the decoding of the second channel decoder 404, which is then able, in the best instance, to completely reconstruct the information sequence $u_2$ being transmitted via the second data source MS2. Then, the second channel decoder output sequence $\hat{u}_{23}$ is equal to the information sequence $u_2$ being transmitted via the second data source MS2. The forwarding of (soft) information from the channel decoder 1 and 2 (400 and 404) to the network decoder 402 via the path 406 and the path 407 and from the network decoder to the channel decoders 1 and 2 via the path 408 and the path 410 has preferably to be repeated several times, whereas the estimation of $u_1$ and $u_2$ at the channel decoders improves with each iteration. In this context it can be mentioned, that the network decoder sequence 406 can comprise additional redundancy or original information for reconstructing the information sent of the both data sources in the both channel decoders 400 and 404. Furthermore, it is also possible that, if the channel 100 as shown in Fig. 2 has a strong fading, the information sent by the first data source MS1 can be completely reconstructed if the network decoder is fed with information transmitted with respect to the second data source MS2. This means that the network decoder 402 can apply a decoding algorithm in which the second channel-encoded sequence of information units $y_{23}$ received by the data sink or the second channel decoder output sequence $\hat{u}_{23}$ are fed via a decoder path 408 to the network decoder 402 in which the received network-encoded sequence of information units and the second channel-encoded sequence of information units $y_{23}$ received by the data sink or the second channel decoder output sequence $\hat{u}_{23}$ are linked in such a way, that the first channel-encoded sequence of information units $y_{13}$ received by the data sink can be used to reconstruct the data $u_1$ to be transmitted by the first data source MS1. In an extreme case, it could also be possible, that the first channel decoder output sequence can be completely reconstructed from the network decoder sequence 406, if the first channel-encoded sequence of information units $y_{14}$ is completely lost in the transmission over the channel 100. Analogously, if the channel 110 as shown in Fig. 2 has a strong fading, the information sent by the second data source MS2 can be completely reconstructed if the network decoder 402 is fed with information transmitted with respect to the first data source MS1. This means that the network decoder 402 can apply a decoding algorithm in which the first channel-encoded sequence of information units $y_{13}$ received by the data sink BS or the first channel decoder output sequence $\hat{u}_{13}$ are fed via a decoder path 410 to the network decoder 402 in which the received network-encoded sequence of information units and the first channel-encoded sequence of information units $y_{13}$ received by the data sink or the first channel decoder output sequence $\hat{u}_{13}$ are linked in such a way, that the second channel-encoded sequence of information units $y_{23}$ received by the data sink can be used to reconstruct the data $u_2$ to be transmitted by the second data source MS2. In an extreme case, it could also be possible, that the first channel decoder output sequence can be completely reconstructed from the network decoder sequence 406, if the second channel-encoded sequence of information units $y_{24}$ is completely lost in the transmission over the channel 110.

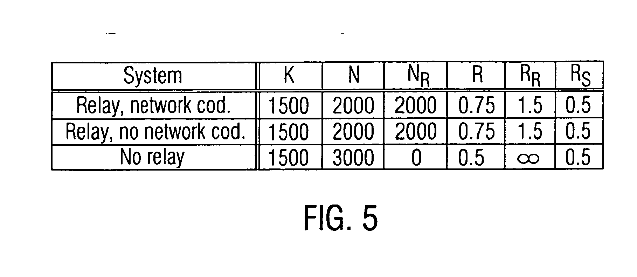

Three systems applying the iterative joint network and channel decoding are compared herein. Simulation results for the system setup with two users, one relay and block Rayleigh fading channels confirm the advantage achieved by the system applying iterative network and channel decoding. We used a regular LDPC code with check nodes with degree $d_C = 6$ and variable nodes with degree $d_V = 3$ and with the parameters which are denoted in the table in Fig. 5. The parameter selection ensures that the same bandwidth is used by the three systems.

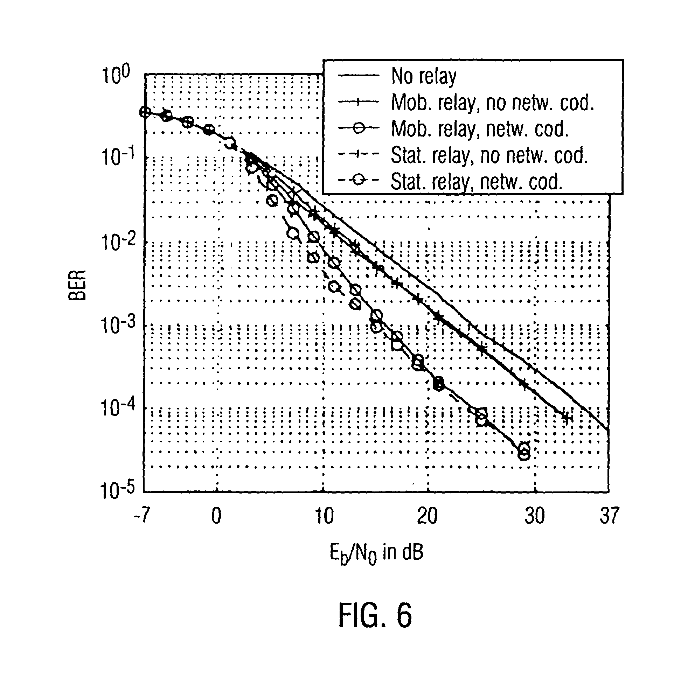

The network-channel code was decoded with the message-passing algorithm with 30 iterations. Figure 6 discloses simulation results for the bit error rate (BER) of the system applying network coding at a stationary (AWGN) or a mobile (block Rayleigh fading) relay. The system achieves a significant gain compared with the reference systems.

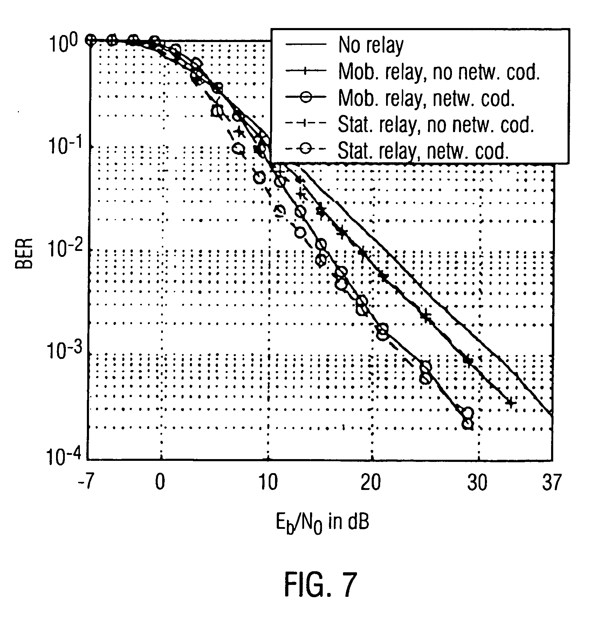

Figure 7 discloses simulation results for the frame error rate (FER) of the system applying network coding at a stationary (AWGN) or a mobile (block Rayleigh fading) relay. The system achieves a significant gain compared with the reference system.

Thus, Fig. 6 depicts the bit error rate (BER) and Fig. 7 the frame error rate (FER) over the signal to noise ratio (SNR) $E_b/N_0$ in dB. The system applying the iterative joint network and channel decoding achieves a significant gain compared with the reference systems. As the system with the relay but without network coding gains much less, we know that the application of network coding is mainly responsible for the gain.

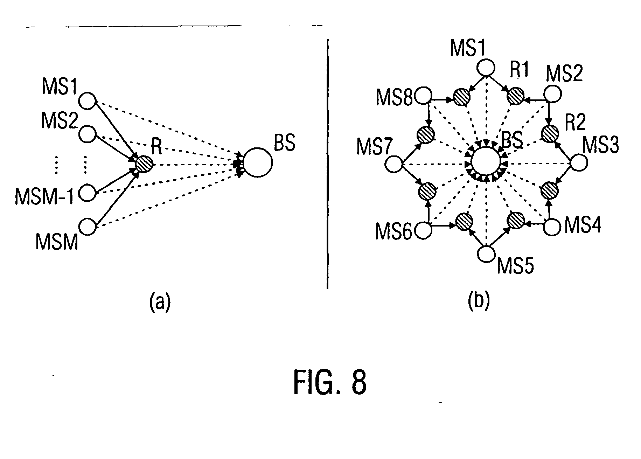

Figure 8 shows two possible setups with more than two sources (users) where joint network-channel decoding can be applied. The information of all sources (users) is decoded jointly on one Tanner graph.

The application of joint network and channel decoding for more than two sources (users) could be done in several ways. For example, several sources (users) could use one relay (see Fig. 8(a)). Another interesting setup would be, if one relay is only used by two sources (users) but one source (user) uses several relays (see Fig. 8(b)). The sources can be mobile data sources or one mobile data source and one fixed data source (e.g. base station).

Fig. 8(b) depicts a possible setup with 8 sources (users) and 8 relays. The data from all sources (users) would be decoded on one graph. For both cases the length of the graph could be enlarged by a high factor. This would improve the performance especially in application where short block lengths are used due to delay constraints.

Further, the generalized hybrid-ARQ protocol of B. Zhao and M. Valenti, "Practical Relay Networks: A Generalization of Hybrid-ARQ", IEEE Journal on Selected Areas in Communications, 23(1):7-18, January 2005 is extended in the following way. Again, the source(s) send channel coded information to the sink. The relays listen to this transmission as well. If a relay is able to decode successfully, it send without any request over an orthogonal channel a packet with additional redundancy to the sink (for example only redundancy is sent to the data sink for an improvement of the reconstruction characteristics in the data sink). This additional redundancy is the output of a network code if the information of several sources was decoded correctly and the output of a channel code if only the information of one source was decoded correctly. The header of this packet contains the information of which source(s) is included in this packet. Therefore, the sink knows which relays have decoded which information successfully and can request more redundancy from one of the sources or the relays until the information of all sources is decoded. This can be decided by certain criteria (e.g. SNR of the connection to the sink and the information of which sources (users) has not been decoded yet). With this extension a contention period is not necessary. However, the receiver can also send an (negative) acknowledge signal to the relay in order to invoke a retransmission of the redundancy to the receiver.

Thus, the combination of routing and an iterative coding scheme is extended to the combination of network coding and an iterative coding scheme. The source(s) use a common relay Ve to send information to one sink. At the source(s) the information is channel encoded and the relay tries to reconstruct the information with a channel decoder. The relay performs network coding, which means that it combines data which were transmitted from different sources. The sink retrieves the channel code bits from the source(s) and the network code bits from the relay.

The channel codes and the network code are described by a single distributed linear block code which is called network-channel code. Here as example a low-density parity-check (LDPC) code is considered. The network-channel code can be decoded at the sink with the iterative message-passing algorithm. Thus, joint network and channel decoding is performed. Furthermore, an exchange of (soft) information between the first and second channel decoders 400, 404 and the network decoder 402 via the paths 406, 407, 408 and 410 can be repeated several times.

The use of a distributed LDPC code for a system with one sink and one relay that does not perform network coding is a special case of the described system. This special case corresponds to the distributed turbo code which was presented in B Zhao and M. Valenti, "Distributed Turbo Coded Diversity for the Rayleigh Channel", Electronic Letters, 39: 786 - 787, 2003.

The proposed approach can be extended easily to the use of several sources, several relays and several sinks.

Furthermore, an extension of the generalized hybrid-ARQ protocol of B. Zhao and M. Valenti, "Practical Relay Networks: A Generalization of Hybrid-ARQ", IEEE Journal on Selected Areas in Communications, 23(1):7-18, January 2005 is proposed where the sink decides if one of the sources or one of the relays sends the next packet. Then no contention period is necessary. The (extended) generalized hybrid-ARQ protocol can be adapted and applied for a system which uses iterative network and channel decoding if the network-channel code is rate-compatible.

To summarize, the present invention considers a communication network with one or several sources, intermediate nodes (relays) and one or several sinks. The intermediate communication channels are band-limited channels with time-varying disturbance.

To enable a reliable and efficient transmission, a distributed linear block code is proposed. The sources channel-encode the data and transmit the encoded data to the nodes and the sink. At the nodes, the data from different sources is combined through a linear network code. At the sink, the channel codes and the network codes are considered jointly and are decoded on a single graph. The decoding on a graph is usually done with a message passing algorithm. Low-density parity-check (LDPC) codes are well suited candidates for this distributed code.

In addition, a hybrid-ARQ protocol with a decentralized node organization is proposed. There, the nodes are able to combine the data from available sources through the network code and to send this additional redundancy to the sink without any explicit request.

Moreover, depending on certain implementation requirements of the inventive methods, the inventive methods can be implemented in hardware or in software. The implementation can be performed using a digital storage medium, in particular a disk or a CD having electronically readable control signals stored thereon, which can cooperate with a programmable computer system such that the inventive methods are performed. Generally, the present invention is, therefore, a computer program product with a program code stored on a machine-readable carrier, the program code being configured for performing the inventive methods, when the computer program product runs on a computer. In other words, the inventive methods are, therefore, a computer program having a program code for performing the inventive methods, when the computer program runs on a computer.

**Claims**

1. Communication relay apparatus (R) for providing a network-channel-encoded information unit sequence ($x_4$), the communication relay apparatus (R) comprising:

   a first channel decoder (204) being configured to supervise a first wireless channel (200), to receive a first channel-encoded sequence of information units ($y_{14}$) from a first data source (MS1) via the first wireless channel (200) and to decode the first channel-encoded sequence of information units ($y_{14}$) to obtain a first decoded sequence of information units ($\hat{u}_{14}$);
   a second channel decoder (206) being configured to supervise a second wireless channel (202), to receive a second channel-encoded sequence of information units ($y_{24}$) from a second data source (MS2) via the second wireless channel (202) and to decode the second channel-encoded sequence of information units ($y_{24}$) to obtain a second decoded sequence of information units ($\hat{u}_{24}$), the first and second wireless channels (200, 202) being different from each other; and
   a network encoder (208) being configured to combine and jointly network-channel-encode information of the first and second decoded sequences of information units ($\hat{u}_{14} \, \hat{u}_{24}$) into the network-channel-encoded information unit sequence ($x_4$), wherein the network encoder (208) is further configured to wirelessly transmit the network-channel-encoded information unit sequence ($x_4$) to a data sink (BS).

2. Communication relay apparatus (R) according to claim 1, wherein the first channel decoder (204) and the second channel decoder (206) are configured to supervise mobile wireless channels (200, 202) and wherein the data sources (MS1, MS2) are mobile data sources.

3. Communication relay apparatus (R) according to one of claims 1 or 2, wherein the network-encoder (208) is configured to perform a network-channel coding using a linear block code or a convolutional code.

4. Communication relay apparatus (R) according to claim 3, wherein the linear block code is a low-density parity-check code.

5. Communication relay apparatus (R) according to one of claims 1 to 4, wherein the network encoder is configured to provide the network-channel-encoded information unit sequence ($x_4$) having a first code rate and wherein the network encoder (208) is configured to provide a further network-channel-encoded information unit sequence ($x_4$) having a second code rate, the first code rate being higher than the second code rate, wherein the network-channel-encoded information unit sequence ($x_4$) having the second code rate comprises the information being included in the network-channel-encoded information unit sequence ($x_4$) having the first code rate.

6. Communication relay apparatus (R) according to one of claims 1 to 5, further comprising:

   a third channel decoder being configured to supervise a third wireless channel, to receive a third channel-encoded sequence of information units from a third data source (MS3) via a third wireless channel and to decode the third channel-encoded sequence of information units to obtain a third decoded sequence of information units, the first, second and third wireless channels being different from each other; and
   wherein the network encoder (208) is configured to network-channel-encode information of the first, second and third decoded sequences of information units into the network-channel-encoded information unit sequence ($x_4$).

7. Communication relay apparatus (R) according to one of claims 1 to 6, wherein the first channel decoder (204) is configured to determine whether the first channel-encoded sequence of information units ($y_{14}$) can be decoded correctly and to provide the first decoded sequence of information units ($\hat{u}_{14}$) comprising redundancy information

for correctly reconstructing a signal ($u_1$) sent by the first data source (MS1) or wherein the second channel decoder (206) is configured to determine whether the second channel-encoded sequence of information units ($y_{24}$) can be decoded correctly and to provide the second decoded sequence of information units ($\hat{u}_{24}$) comprising redundancy information for correctly reconstructing a signal ($u_2$) sent by the second data source (MS2).

8.  Communication relay apparatus (R) according to claim 7, wherein the network encoder (208) is configured to receive an acknowledge signal from the data sink (BS) and wherein the network encoder (208) is configured to, in response to the acknowledge signal, transmit further network-channel-encoded information.

9.  Communication relay system comprising:

    a first communication relay apparatus (R1) according to one of claims 1 to 8, wherein the first channel decoder of the first communication relay apparatus (R1) is configured to receive the first channel-encoded sequence of information units from the first data source (MS1), wherein the second channel decoder of the first communication relay apparatus (R1) is configured to receive the second channel-encoded sequence of information units from the second data source (MS2) and wherein the network encoder of the first communication relay apparatus (R1) is configured to provide a first network-channel-encoded information unit sequence and to transmit the first network-encoded information unit sequence to the data sink (BS); and

    a second communication relay apparatus (R2) according to one of claims 1 to 8, wherein the first channel decoder of the second communication relay apparatus (R2) is configured to receive a third or the third channel-encoded sequence of information units from a respective third data source (MS3), wherein the second channel decoder of the second communication relay apparatus (R2) is configured to receive the second channel-encoded sequence of information units from the second data source (MS2) and wherein the network encoder of the second communication relay apparatus (R2) is configured to provide a second network-channel-encoded information unit sequence and to transmit the second network-channel-encoded information unit sequence to the data sink (BS).

10. Method for providing a network-channel-encoded information unit sequence ($x_4$) comprising the steps of:

    receiving a first channel-encoded sequence of information units ($y_{14}$) from a first data source (MS1) via a first wireless channel (200) and to decode the first channel-encoded sequence of information units ($y_{14}$) to obtain a first decoded sequence of information units ($\hat{u}_{14}$);

    receiving a second channel-encoded sequence of information units ($y_{24}$) from a second data source (MS2) via a second wireless channel (202) and to decode the second channel-encoded sequence of information units ($y_{24}$) to obtain a second decoded sequence of information units ($\hat{u}_{24}$), the first and second wireless channels (200, 202) being different from each other;

    combining and jointly network-channel-encoding information of the first and second decoded sequences of information units ($\hat{u}_{14}$, $\hat{u}_{24}$) into the network-channel-encoded information unit sequence ($x_4$) ; and

    wirelessly transmitting the network-channel-encoded information unit sequence ($x_4$) to a data sink (BS).

11. Communication receiver (BS) for providing a first and a second channel decoder output sequence ($\hat{u}_{13}$, $\hat{u}_{23}$), the communication receiver (BS) comprising:

    a network decoder (402) being configured to receive a network-channel-encoded sequence of information units ($y_{43}$), the network-channel-encoded sequence of information units ($y_{43}$) comprising information of a first and a second data source (MS1, MS2) that has been transmitted on a first and a second wireless channel respectively, wherein the network decoder (402) is configured to decode the network-channel-encoded sequence of information units ($y_{43}$) into network decoder sequences (406, 407);

    a first channel decoder (400) being configured to receive a first channel-encoded sequence of information units ($y_{13}$) from a first data source (MS1) via a first channel (100) and to decode the first channel-encoded sequence of information units ($y_{13}$) using the network decoder sequence (406) to obtain the first channel decoder output sequence ($\hat{u}_{13}$); and

    a second channel decoder (404) being configured to receive a second channel-encoded sequence of information units ($y_{23}$) from a second data source (MS2) via a second channel (110), the first and second channels (100, 110) being different from each other, wherein the second channel decoder (404) is further configured to decode the second channel-encoded sequence of information units ($y_{23}$) using the network decoder sequence (407) to obtain the second channel decoder output sequence ($\hat{u}_{23}$).

**12.** Communication receiver (BS) according to claim 11, wherein the first channel decoder (400) is configured to provide a first soft decoder information sequence (410), wherein the second channel decoder (404) is configured to provide a second soft decoder information sequence (408), and wherein the network decoder (402) is configured to receive the first or second soft decoder information sequences (408, 410) and to decode the network-channel-encoded sequence of information units ($y_{43}$) in response to the first or second soft decoder information sequences (408, 410).

**13.** Communication receiver (BS) according to claim 11 or 12, wherein the first channel decoder (400) and the second channel decoder (404) are configured to supervise mobile wireless channels (100, 110) and wherein the data sources (MS1, MS2) are mobile data sources.

**14.** Communication receiver (BS) according to one of claims 11 to 13, wherein the network decoder (402) is configured to perform a network-channel decoding using a linear block code or convolutional code.

**15.** Communication receiver (BS) according to claim 14, wherein the linear block code is a low-density parity-check code.

**16.** Communication receiver (BS) according to one of claims 11 to 15, wherein network decoder (402) is configured to receive the network-channel-encoded information unit sequence ($y_{43}$) having a first code rate and wherein the network encoder (402) is configured to provide a further network-channel-encoded information unit sequence ($y_{43}$) having a second code rate, the first and second code rates being different from each other.

**17.** Communication receiver (BS) according to one of claims 11 to 16, wherein the network decoder (406) is configured to network-decode the network-channel-encoded sequence of information units ($y_{43}$) comprising information of a first, second and third data source (MS1, MS2, MS3), wherein the network decoder (402) is configured to decode the network-channel-encoded sequence of information units ($y_{43}$) into network decoder sequences (406, 407, 409), the communication receiver (BS) further comprising:

a third channel decoder being configured to supervise a third channel, to receive a third channel-encoded sequence of information units from a third data source (MS3) via a third channel and to decode the third channel-encoded sequence of information units using the network decoder sequence (409) to obtain a third channel decoder output sequence, the first, second and third channels being different from each other.

**18.** Communication receiver (BS) according to one of claims 11 to 17, wherein the first channel decoder (400), the second channel decoder (404) and the network decoder (402) are configured to determine whether the encoded sequences of information units ($y_{13}$, $y_{23}$, $y_{43}$) can be decoded correctly and to send a negative acknowledge signal to a communication relay apparatus (R) in the case, the encoded sequences of information units ($y_{13}$, $y_{23}$, $y_{43}$) cannot be decoded correctly or wherein the second channel decoder (404) is configured to determine whether the first channel-encoded sequence of information units ($y_{23}$) can be decoded correctly and to send an acknowledge signal to the communication relay apparatus (R) in the case, the second channel-encoded sequence of information units ($y_{23}$) cannot be decoded correctly.

**19.** Communication receiver (BS) according to claim 17, wherein the network decoder (402) is configured to decode, in response to the acknowledge signal sent to the communication relay apparatus (R), redundancy information from the network-channel-encoded sequence of information units ($y_{43}$) for the first channel decoder (400) for correctly reconstruct the signal ($u_1$) sent by the first data source (MS1) or wherein the network decoder (402) is configured to decode, in response to the acknowledge signal, redundancy information from the network-channel-encoded sequence of information units ($y_{43}$) for the second channel decoder (402) for correctly reconstruct the signal ($u_1$) sent by the second data source (MS2).

**20.** Communication receiver system comprising:

a communication receiver (BS) according to one of claims 11 to 19; and
a communication relay apparatus (R) according to one of claims 1 to 8 or a communication relay system according to claim 9.

**21.** Method for providing a first and a second channel decoder output sequence ($\hat{u}_{13}$, $\hat{u}_{23}$), the method being adapted to receive a network-channel-encoded sequence being output according to a method according to claim 10, the method for providing comprising the steps of:

receiving a network-channel-encoded sequence of information units ($y_{43}$) with a network decoder (402), the network-encoded sequence of information units ($y_{43}$) comprising information of a first and second data source (MS1, MS2);

decoding the network-channel-encoded sequence of information units ($y_{43}$) into a network decoder sequences (406, 409);

receiving a first channel-encoded sequence of information units ($y_{13}$) from said first data source (MS1) with a first channel decoder (400) via a first channel (100);

decoding the first channel-encoded sequence of information units ($y_{13}$) with the first channel decoder (400) using the network decoder sequence (406) to obtain the first channel decoder output sequence ($û_{13}$);

receiving a second channel-encoded sequence of information units ($y_{23}$) from said second data source (MS2) with a second channel decoder (404) via a second channel (110), the first and second channels (100, 110) being different from each other;

decoding the second channel-encoded sequence of information units ($y_{23}$) with the second channel decoder (404) using the network decoder sequence to obtain the second channel decoder output sequence ($û_{23}$).

**22.** Method according to claim 21, further comprising the step of:

Providing a first soft decoder information sequence (410) by the first channel decoder (400);

Providing a second soft decoder information sequence (408) by the second channel decoder (404);

Decoding the network-channel-encoded sequence of information units ($y_{43}$) in the network decoder (402) using the first soft decoder information sequence (410) or the second soft decoder information sequence (408) in order to provide a first network decoder sequence (406) and a second network decoder sequence (407);

Providing a further first soft decoder information sequence (410) and a further first channel decoder output sequence ($û_{13}$) by the first channel decoder (400) using the first network decoder sequence (406);

Providing a further second soft decoder information sequence (408) and a further second channel decoder output sequence ($û_{23}$) by the second channel decoder (404) using the second network decoder sequence (407);

Decoding the network-channel-encoded sequence of information units ($y_{43}$) in the network decoder (402) using the further first soft decoder information sequence (410) or the further second soft decoder information sequence (408) in order to provide an improved first network decoder sequence (406) and an improved second network decoder sequence (407) ;

Providing an additional first soft decoder information sequence (410) and an additional first channel decoder output sequence ($û_{13}$) by the first channel decoder (400) using the improved first network decoder sequence (406);

Providing an additional second soft decoder information sequence (408) and an additional second channel decoder output sequence ($û_{23}$) by the second channel decoder (404) using the improved second network decoder sequence (407);

**23.** Computer program having a program code for performing the methods according to one of claims 10 or 21, when the computer program runs on a computer.

**Patentansprüche**

**1.** Kommunikationsweiterleitungsvorrichtung (R) zum Liefern einer netzwerkkanalcodierten Informationseinheitssequenz ($x_4$), wobei die Kommunikationsweiterleitungsvorrichtung (R) folgende Merkmale aufweist:

einen ersten Kanaldecodierer (204), der dahin gehend konfiguriert ist, einen ersten drahtlosen Kanal (200) zu überwachen, eine erste kanalcodierte Sequenz von Informationseinheiten ($y_{14}$) von einer ersten Datenquelle (MS1) über den ersten drahtlosen Kanal (200) zu empfangen und die erste kanalcodierte Sequenz von Informationseinheiten ($y_{14}$) zu decodieren, um eine erste decodierte Sequenz von Informationseinheiten ($û_{14}$) zu erhalten;

einen zweiten Kanaldecodierer (206), der dahin gehend konfiguriert ist, einen zweiten drahtlosen Kanal (202) zu überwachen, eine zweite kanalcodierte Sequenz von Informationseinheiten ($y_{24}$) von einer zweiten Datenquelle (MS2) über den zweiten drahtlosen Kanal (202) zu empfangen und die zweite kanalcodierte Sequenz von Informationseinheiten ($y_{24}$) zu decodieren, um eine zweite decodierte Sequenz von Informationseinheiten ($û_{24}$) zu erhalten, wobei sich der erste und der zweite drahtlose Kanal (200, 202) voneinander unterscheiden; und

einen Netzwerkcodierer (208), der dahin gehend konfiguriert ist, Informationen der ersten und der zweiten decodierten Sequenz von Informationseinheiten ($û_{14}$, $û_{24}$) zu der netzwerkkanalcodierten Informationseinheits-

sequenz ($x_4$) zu kombinieren und gemeinsam zu netzwerkkanalcodieren, wobei der Netzwerkcodierer (208) ferner dahin gehend konfiguriert ist, die netzwerkkanalcodierte Informationseinheitssequenz ($x_4$) auf drahtlose Weise an eine Datensenke (BS) zu übertragen.

2. Kommunikationsweiterleitungsvorrichtung (R) gemäß Anspruch 1, bei der der erste Kanaldecodierer (204) und der zweite Kanaldecodierer (206) dahin gehend konfiguriert sind, mobile drahtlose Kanäle (200, 202) zu überwachen, und bei der die Datenquellen (MS1, MS2) mobile Datenquellen sind.

3. Kommunikationsweiterleitungsvorrichtung (R) gemäß einem der Ansprüche 1 oder 2, bei der der Netzwerkcodierer (208) dahin gehend konfiguriert ist, unter Verwendung eines linearen Blockcodes oder eines Faltungscodes eine Netzwerkkanalcodierung durchzuführen.

4. Kommunikationsweiterleitungsvorrichtung (R) gemäß Anspruch 3, bei der der lineare Blockcode ein Niedrigdichte-Paritätsprüfung-Code ist.

5. Kommunikationsweiterleitungsvorrichtung (R) gemäß einem der Ansprüche 1 bis 4, bei der der Netzwerkcodierer dahin gehend konfiguriert ist, die netzwerkkanalcodierte Informationseinheitssequenz ($x_4$), die eine erste Coderate aufweist, zu liefern, und bei der der Netzwerkcodierer (208) dahin gehend konfiguriert ist, eine weitere netzwerk-kanalcodierte Informationseinheitssequenz ($x_4$), die eine zweite Coderate aufweist, zu liefern, wobei die erste Coderate höher ist als die zweite Coderate, bei der die netzwerkkanalcodierte Informationseinheitssequenz ($x_4$), die die zweite Coderate aufweist, die Informationen umfasst, die in der netzwerkkanalcodierten Informationseinheits-sequenz ($x_4$), die die erste Coderate aufweist, enthalten sind.

6. Kommunikationsweiterleitungsvorrichtung (R) gemäß einem der Ansprüche 1 bis 5, die ferner folgende Merkmale aufweist:

   einen dritten Kanaldecodierer, der dahin gehend konfiguriert ist, einen dritten drahtlosen Kanal zu überwachen, eine dritte kanalcodierte Sequenz von Informationseinheiten von einer dritten Datenquelle (MS3) über einen dritten drahtlosen Kanal zu empfangen und die dritte kanalcodierte Sequenz von Informationseinheiten zu decodieren, um eine dritte decodierte Sequenz von Informationseinheiten zu erhalten, wobei sich der erste, der zweite und der dritte drahtlose Kanal voneinander unterscheiden; und
   wobei der Netzwerkcodierer (208) dahin gehend konfiguriert ist, Informationen der ersten, der zweiten und der dritten decodierten Sequenz von Informationseinheiten in die netzwerkkanalcodierte Informationseinheitsse-quenz ($x_4$) zu netzwerkkanalcodieren.

7. Kommunikationsweiterleitungsvorrichtung (R) gemäß einem der Ansprüche 1 bis 6, bei der der erste Kanaldecodierer (204) dahin gehend konfiguriert ist, zu bestimmen, ob die erste kanalcodierte Sequenz von Informationseinheiten ($y_{14}$) korrekt decodiert werden kann, und die erste decodierte Sequenz von Informationseinheiten ($\hat{u}_{14}$), die Red-undanzinformationen zum korrekten Rekonstruieren eines durch die erste Datenquelle (MS1) gesendeten Signals ($u_1$) umfassen, zu liefern, oder bei der der zweite Kanaldecodierer (206) dahin gehend konfiguriert ist, zu bestimmen, ob die zweite kanalcodierte Sequenz von Informationseinheiten ($y_{24}$) korrekt decodiert werden kann, und die zweite decodierte Sequenz von Informationseinheiten ($\hat{u}_{24}$), die Redundanzinformationen zum korrekten Rekonstruieren eines durch die zweite Datenquelle (MS2) gesendeten Signals ($u_2$) umfassen, zu liefern.

8. Kommunikationsweiterleitungsvorrichtung (R) gemäß Anspruch 7, bei der der Netzwerkcodierer (208) dahin gehend konfiguriert ist, ein Bestätigungssignal von der Datensenke (BS) zu empfangen, und bei der der Netzwerkcodierer (208) dahin gehend konfiguriert ist, ansprechend auf das Bestätigungssignal weitere netzwerkkanalcodierte Informationen zu übertragen.

9. Kommunikationsweiterleitungssystem, das folgende Merkmale aufweist:

   eine erste Kommunikationsweiterleitungsvorrichtung (R1) gemäß einem der Ansprüche 1 bis 8, bei der der erste Kanaldecodierer der ersten Kommunikationsweiterleitungsvorrichtung (R1) dahin gehend konfiguriert ist, die erste kanalcodierte Sequenz von Informationseinheiten von der ersten Datenquelle (MS1) zu empfangen, bei der der zweite Kanaldecodierer der ersten Kommunikationsweiterleitungsvorrichtung (R1) dahin gehend konfiguriert ist, die zweite kanalcodierte Sequenz von Informationseinheiten von der zweiten Datenquelle (MS2) zu empfangen, und bei der der Netzwerkcodierer der ersten Kommunikationsweiterleitungsvorrichtung (R1) dahin gehend konfiguriert ist, eine erste netzwerkkanalcodierte Informationseinheitssequenz zu liefern und die erste netzwerkcodierte Informationseinheitssequenz an die Datensenke (BS) zu übertragen; und eine zweite Kommunikationsweiterleitungsvorrichtung (R2) gemäß einem der Ansprüche 1 bis 8, bei der der erste Kanaldecodierer der zweiten Kommunikationsweiterleitungsvorrichtung (R2) dahin gehend konfiguriert ist, eine dritte oder die dritte kanalcodierte Sequenz von Informationseinheiten von einer jeweiligen dritten Datenquelle (MS3) zu empfangen, bei der der zweite Kanaldecodierer der zweiten Kommunikationsweiterleitungsvorrichtung (R2) dahin gehend konfiguriert ist, die zweite kanalcodierte Sequenz von Informationseinheiten von der zweiten Datenquelle (MS2) zu empfangen, und bei der der Netzwerkcodierer der zweiten Kommunikationsweiterleitungsvorrichtung (R2) dahin gehend konfiguriert ist, eine zweite netzwerkkanalcodierte Informationseinheitssequenz zu liefern und die zweite netzwerkkanalcodierte Informationseinheitssequenz an die Datensenke (BS) zu übertragen.

**10.** Verfahren zum Liefern einer netzwerkkanalcodierten Informationseinheitssequenz ($x_4$), das folgende Schritte umfasst:

Empfangen einer ersten kanalcodierten Sequenz von Informationseinheiten ($y_{14}$) von einer ersten Datenquelle (MS1) über einen ersten drahtlosen Kanal (200), und um die erste kanalcodierte Sequenz von Informationseinheiten ($y_{14}$) zu decodieren, um eine erste decodierte Sequenz von Informationseinheiten ($\hat{u}_{14}$) zu erhalten;
Empfangen einer zweiten kanalcodierten Sequenz von Informationseinheiten ($y_{24}$) von einer zweiten Datenquelle (MS2) über einen zweiten drahtlosen Kanal (202), und um die zweite kanalcodierte Sequenz von Informationseinheiten ($y_{24}$) zu decodieren, um eine zweite decodierte Sequenz von Informationseinheiten ($\hat{u}_{24}$) zu erhalten, wobei sich der erste und der zweite drahtlose Kanal (200, 202) voneinander unterscheiden;
Kombinieren und gemeinsames Netzwerkkanalcodieren von Informationen der ersten und der zweiten decodierten Sequenz von Informationseinheiten ($\hat{u}_{14}$, $\hat{u}_{24}$) zu der netzwerkkanalcodierten Informationseinheitssequenz ($x_4$) ; und
drahtloses Übertragen der netzwerkkanalcodierten Informationseinheitssequenz ($x_4$) an eine Datensenke (BS).

**11.** Kommunikationsempfänger (BS) zum Liefern einer ersten und einer zweiten Kanaldecodiererausgabesequenz ($\hat{u}_{13}$, $\hat{u}_{23}$), wobei der Kommunikationsempfänger (BS) folgende Merkmale aufweist:

einen Netzwerkdecodierer (402), der dahin gehend konfiguriert ist, eine netzwerkkanalcodierte Sequenz von Informationseinheiten ($y_{43}$) zu empfangen, wobei die netzwerkkanalcodierte Sequenz von Informationseinheiten ($y_{43}$) Informationen einer ersten und einer zweiten Datenquelle (MS1, MS2) umfasst, die auf einem ersten beziehungsweise einem zweiten drahtlosen Kanal übertragen wurde, wobei der Netzwerkdecodierer (402) dahin gehend konfiguriert ist, die netzwerkkanalcodierte Sequenz von Informationseinheiten ($y_{43}$) zu Netzwerkdecodierersequenzen (406, 407) zu decodieren;
einen ersten Kanaldecodierer (400), der dahin gehend konfiguriert ist, eine erste kanalcodierte Sequenz von Informationseinheiten ($y_{13}$) von einer ersten Datenquelle (MS1) über einen ersten Kanal (100) zu empfangen und die erste kanalcodierte Sequenz von Informationseinheiten ($y_{13}$) unter Verwendung der Netzwerkdecodierersequenz (406) zu decodieren, um die erste Kanaldecodiererausgabesequenz ($\hat{u}_{13}$) zu erhalten; und
einen zweiten Kanaldecodierer (404), der dahin gehend konfiguriert ist, eine zweite kanalcodierte Sequenz von Informationseinheiten ($y_{23}$) von einer zweiten Datenquelle (MS2) über einen zweiten Kanal (110) zu empfangen, wobei sich der erste und der zweite Kanal (100, 110) voneinander unterscheiden, wobei der zweite Kanaldecodierer (404) ferner dahin gehend konfiguriert ist, die zweite kanalcodierte Sequenz von Informationseinheiten ($y_{23}$) unter Verwendung der Netzwerkdecodierersequenz (407) zu decodieren, um die zweite Kanaldecodiererausgabesequenz ($\hat{u}_{23}$) zu erhalten.

**12.** Kommunikationsempfänger (BS) gemäß Anspruch 11, bei dem der erste Kanaldecodierer (400) dahin gehend konfiguriert ist, eine erste weiche Decodiererinformationssequenz (410) zu liefern, bei dem der zweite Kanaldecodierer (404) dahin gehend konfiguriert ist, eine zweite weiche Decodiererinformationssequenz (408) zu liefern, und bei dem der Netzwerkdecodierer (402) dahin gehend konfiguriert ist, die erste oder die zweite weiche Decodiererinformationssequenz (408, 410) zu empfangen und die netzwerkkanalcodierte Sequenz von Informationseinheiten ($y_{43}$) ansprechend auf die erste oder die zweite weiche Decodiererinformationssequenz (408, 410) zu decodieren.

**13.** Kommunikationsempfänger (BS) gemäß Anspruch 11 oder 12, bei dem der erste Kanaldecodierer (400) und der zweite Kanaldecodierer (404) dahin gehend konfiguriert sind, mobile drahtlose Kanäle (100, 110) zu überwachen, und bei dem die Datenquellen (MS1, MS2) mobile Datenquellen sind.

**14.** Kommunikationsempfänger (BS) gemäß einem der Ansprüche 11 bis 13, bei dem der Netzwerkdecodierer (402) dahin gehend konfiguriert ist, unter Verwendung eines linearen Blockcodes oder eines Faltungscodes eine Netzwerkkanaldecodierung durchzuführen.

**15.** Kommunikationsempfänger (BS) gemäß Anspruch 14, bei dem der lineare Blockcode ein Niedrigdichte-Paritätsprüfung-Code ist.

**16.** Kommunikationsempfänger (BS) gemäß einem der Ansprüche 11 bis 15, bei dem der Netzwerkdecodierer (402) dahin gehend konfiguriert ist, die netzwerkkanalcodierte Informationseinheitssequenz ($y_{43}$), die eine erste Coderate aufweist, zu empfangen, und bei dem der Netzwerkcodierer (402) dahin gehend konfiguriert ist, eine weitere netzwerkkanalcodierte Informationseinheitssequenz ($y_{43}$), die eine zweite Coderate aufweist, zu liefern, wobei sich die erste und die zweite Coderate voneinander unterscheiden.

**17.** Kommunikationsempfänger (BS) gemäß einem der Ansprüche 11 bis 16, bei dem der Netzwerkdecodierer (406) dahin gehend konfiguriert ist, die netzwerkkanalcodierte Sequenz von Informationseinheiten ($y_{43}$), die Informationen einer ersten, einer zweiten und einer dritten Datenquelle (MS1, MS2, MS3) umfasst, zu netzwerkdecodieren, bei dem der Netzwerkdecodierer (402) dahin gehend konfiguriert ist, die netzwerkkanalcodierte Sequenz von Informationseinheiten ($y_{43}$) zu Netzwerkdecodierersequenzen (406, 407, 409) zu decodieren, wobei der Kommunikationsempfänger (BS) ferner folgendes Merkmal aufweist:

einen dritten Kanaldecodierer, der dahin gehend konfiguriert ist, einen dritten Kanal zu überwachen, eine dritte kanalcodierte Sequenz von Informationseinheiten von einer dritten Datenquelle (MS3) über einen dritten Kanal zu empfangen und die dritte kanalcodierte Sequenz von Informationseinheiten unter Verwendung der Netzwerkdecodierersequenz (409) zu decodieren, um eine dritte Kanaldecodiererausgabesequenz zu erhalten, wobei sich der erste, der zweite und der dritte Kanal voneinander unterscheiden.

**18.** Kommunikationsempfänger (BS) gemäß einem der Ansprüche 11 bis 17, bei dem der erste Kanaldecodierer (400), der zweite Kanaldecodierer (404) und der Netzwerkdecodierer (402) dahin gehend konfiguriert sind, zu bestimmen, ob die codierten Sequenzen von Informationseinheiten ($y_{13}$, $y_{23}$, $y_{43}$) korrekt decodiert werden können, und in dem Fall, dass die codierten Sequenzen von Informationseinheiten ($y_{13}$, $y_{23}$, $y_{43}$) nicht korrekt decodiert werden können, ein negatives Bestätigungssignal an eine Kommunikationsweiterleitungsvorrichtung (R) zu senden, oder bei dem der zweite Kanaldecodierer (404) dahin gehend konfiguriert ist, zu bestimmen, ob die erste kanalcodierte Sequenz von Informationseinheiten ($y_{23}$) korrekt decodiert werden kann, und in dem Fall, dass die zweite kanalcodierte Sequenz von Informationseinheiten ($y_{23}$) nicht korrekt decodiert werden kann, ein Bestätigungssignal an die Kommunikationsweiterleitungsvorrichtung (R) zu senden.

**19.** Kommunikationsempfänger (BS) gemäß Anspruch 17, bei dem der Netzwerkdecodierer (402) dahin gehend konfiguriert ist, ansprechend auf das an die Kommunikationsweiterleitungsvorrichtung (R) gesendete Bestätigungssignal Redundanzinformationen von der netzwerkkanalcodierten Sequenz von Informationseinheiten ($y_{43}$) für den ersten Kanaldecodierer (400) zu decodieren, um das durch die erste Datenquelle (MS1) gesendete Signal ($u_1$) korrekt zu rekonstruieren, oder bei dem der Netzwerkdecodierer (402) dahin gehend konfiguriert ist, ansprechend auf das Bestätigungssignal Redundanzinformationen von der netzwerkkanalcodierten Sequenz von Informationseinheiten ($y_{43}$) für den zweiten Kanaldecodierer (402) zu decodieren, um das durch die zweite Datenquelle (MS2) gesendete Signal ($u_1$) korrekt zu rekonstruieren.

**20.** Kommunikationsempfängersystem, das folgende Merkmale aufweist:

einen Kommunikationsempfänger (BS) gemäß einem der Ansprüche 11 bis 19; und
eine Kommunikationsweiterleitungsvorrichtung (R) gemäß einem der Ansprüche 1 bis 8 oder ein Kommunikationsweiterleitungssystem gemäß Anspruch 9.

**21.** Verfahren zum Liefern einer ersten und einer zweiten Kanaldecodiererausgabesequenz ($\hat{u}_{13}$, $\hat{u}_{23}$), wobei das Verfahren dahin gehend angepasst ist, eine netzwerkkanalcodierte Sequenz zu empfangen, die gemäß einem Verfahren gemäß Anspruch 10 ausgegeben wird, wobei das Verfahren zum Liefern folgende Schritte umfasst:

Empfangen einer netzwerkkanalcodierten Sequenz von Informationseinheiten ($y_{43}$) mit einem Netzwerkdecodierer (402), wobei die netzwerkcodierte Sequenz von Informationseinheiten ($y_{43}$) Informationen einer ersten und einer zweiten Datenquelle (MS1, MS2) umfasst;
Decodieren der netzwerkkanalcodierten Sequenz von Informationseinheiten ($y_{43}$) zu einer Netzwerkdecodie-

rersequenz (406, 409);

Empfangen einer ersten kanalcodierten Sequenz von Informationseinheiten ($y_{13}$) von der ersten Datenquelle (MS1) mit einem ersten Kanaldecodierer (400) über einen ersten Kanal (100);

Decodieren der ersten kanalcodierten Sequenz von Informationseinheiten ($y_{13}$) mit dem ersten Kanaldecodierer (400) unter Verwendung der Netzwerkdecodierersequenz (406), um die erste Kanaldecodiererausgabesequenz ($\hat{u}_{13}$) zu erhalten;

Empfangen einer zweiten kanalcodierten Sequenz von Informationseinheiten ($y_{23}$) von der zweiten Datenquelle (MS2) mit einem zweiten Kanaldecodierer (404) über einen zweiten Kanal (110), wobei sich der erste und der zweite Kanal (100, 110) voneinander unterscheiden;

Decodieren der zweiten kanalcodierten Sequenz von Informationseinheiten ($y_{23}$) mit dem zweiten Kanaldecodierer (404) unter Verwendung der Netzwerkdecodierersequenz, um die zweite Kanaldecodiererausgabesequenz ($\hat{u}_{23}$) zu erhalten.

**22.** Verfahren gemäß Anspruch 21, das ferner folgenden Schritt umfasst:

Liefern einer ersten weichen Decodiererinformationssequenz (410) durch den ersten Kanaldecodierer (400);

Liefern einer zweiten weichen Decodiererinformationssequenz (408) durch den zweiten Kanaldecodierer (404);

Decodieren der netzwerkkanalcodierten Sequenz von Informationseinheiten ($y_{43}$) in dem Netzwerkdecodierer (402) unter Verwendung der ersten weichen Decodiererinformationssequenz (410) oder der zweiten weichen Decodiererinformationssequenz (408), um eine erste Netzwerkdecodierersequenz (406) und eine zweite Netzwerkdecodierersequenz (407) zu liefern;

Liefern einer weiteren ersten weichen Decodiererinformationssequenz (410) und einer weiteren ersten Kanaldecodiererausgabesequenz ($\hat{u}_{13}$) durch den ersten Kanaldecodierer (400) unter Verwendung der ersten Netzwerkdecodierersequenz (406);

Liefern einer weiteren zweiten weichen Decodiererinformationssequenz (408) und einer weiteren zweiten Kanaldecodiererausgabesequenz ($\hat{u}_{23}$) durch den zweiten Kanaldecodierer (404) unter Verwendung der zweiten Netzwerkdecodierersequenz (407);

Decodieren der netzwerkkanalcodierten Sequenz von Informationseinheiten ($y_{43}$) in dem Netzwerkdecodierer (402) unter Verwendung der weiteren ersten weichen Decodiererinformationssequenz (410) oder der weiteren zweiten weichen Decodiererinformationssequenz (408), um eine verbesserte erste Netzwerkdecodierersequenz (406) und eine verbesserte zweite Netzwerkdecodierersequenz (407) zu liefern;

Liefern einer zusätzlichen ersten weichen Decodiererinformationssequenz (410) und einer zusätzlichen ersten Kanaldecodiererausgabesequenz ($\hat{u}_{13}$) durch den ersten Kanaldecodierer (400) unter Verwendung der verbesserten ersten Netzwerkdecodierersequenz (406);

Liefern einer zusätzlichen zweiten weichen Decodiererinformationssequenz (408) und einer zusätzlichen zweiten Kanaldecodiererausgabesequenz ($\hat{u}_{23}$) durch den zweiten Kanaldecodierer (404) unter Verwendung der verbesserten zweiten Netzwerkdecodierersequenz (407).

**23.** Computerprogramm, das einen Programmcode zum Durchführen der Verfahren gemäß einem der Ansprüche 10 oder 21 aufweist, wenn das Computerprogramm auf einem Computer abläuft.

## Revendications

**1.** Dispositif de relais de communication (R) pour fournir une séquence d'unités d'information codée par réseau/canal ($x_4$), le dispositif de relais de communication (R) comprenant:

un premier décodeur de canal (204) configuré de manière à surveiller un premier canal sans fil (200), à recevoir une première séquence d'unités d'information codée par canal ($y_{14}$) d'une première source de données (MS1) via le premier canal sans fil (200) et à décoder la première séquence d'unités d'information codée par canal ($y_{14}$), pour obtenir une première séquence d'unités d'information décodée ($\hat{u}_{14}$);

un deuxième décodeur de canal (206) configuré de manière à surveiller un deuxième canal sans fil (202), à recevoir une deuxième séquence d'unités d'information codée par canal ($y_{24}$) d'une deuxième source de données (MS2) via le deuxième canal sans fil (202) et à décoder la deuxième séquence d'unités d'information codée par canal ($y_{24}$), pour obtenir une deuxième séquence d'unités d'information décodée ($\hat{u}_{24}$), les premier et deuxième canaux sans fil (200, 202) étant différents l'un de l'autre; et

un codeur de réseau (208) configuré de manière à combiner et coder conjointement par réseau/canal les informations des première et deuxième séquences d'unités d'information décodées ($\hat{u}_{14}$, $\hat{u}_{24}$), pour obtenir la

séquence d'unités d'information codée par réseau/canal ($x_4$), dans lequel le codeur de réseau (208) est, par ailleurs, configuré de manière à transmettre sans fil la séquence d'unités d'information codée par réseau/canal ($x_4$) à un bloc récepteur de données (BS).

2. Dispositif de relais de communication (R) selon la revendication 1, dans lequel le premier décodeur de canal (204) et le deuxième décodeur de canal (206) sont configurés de manière à surveiller des canaux mobiles sans fil (200, 202) et dans lequel les sources de données (MS1, MS2) sont des sources de données mobiles.

3. Dispositif de relais de communication (R) selon l'une des revendications 1 ou 2, dans lequel le codeur de réseau (208) est configuré de manière à effectuer un codage de réseau/canal au moyen d'un code de bloc linéaire ou d'un code convolutionnel.

4. Dispositif de relais de communication (R) selon la revendication 3, dans lequel le code de bloc linéaire est un code de contrôle de parité de faible densité.

5. Dispositif de relais de communication (R) selon l'une des revendications 1 à 4, dans lequel le codeur de réseau est configuré de manière à fournir la séquence d'unités d'information codée par réseau/canal ($x_4$) présentant un premier taux de code et dans lequel le codeur de réseau (208) est configuré de manière à fournir une autre séquence d'unités d'information codée par réseau/canal ($x_4$) présentant un deuxième taux de code, le premier taux de code étant supérieur au deuxième taux de code, dans lequel la séquence d'unités d'information codée par réseau/canal ($x_4$) présentant le deuxième taux de code comprend les informations comprises dans la séquence d'unités d'information codée par réseau/canal ($x_4$) présentant le premier taux de code.

6. Dispositif de relais de communication (R) selon l'une des revendications 1 à 5, comprenant par ailleurs:

   un troisième décodeur de canal configuré de manière à surveiller un troisième canal sans fil, à recevoir une troisième séquence d'unités d'information codée par canal d'une troisième source de données (MS3) via un troisième canal sans fil et à décoder la troisième séquence d'unités d'information codée par canal pour obtenir une troisième séquence d'unités d'information décodée, les premier, deuxième et troisième canaux sans fil étant différents l'un de l'autre; et
   dans lequel le codeur de réseau (208) est configuré de manière à coder par réseau/canal les informations des première, deuxième et troisième séquences d'unités d'information décodées, pour obtenir la séquence d'unités d'information codée par réseau/canal ($x_4$).

7. Dispositif de relais de communication (R) selon l'une des revendications 1 à 6, dans lequel le premier décodeur de canal (204) est configuré de manière à déterminer si la première séquence d'unités d'information codée par canal ($y_{14}$) peut être décodée correctement et à fournir la première séquence d'unités d'information décodée ($\hat{u}_{14}$) comprenant des informations de redondance pour reconstruire correctement un signal ($u_1$) envoyé par la première source de données (MS1) ou dans lequel le deuxième décodeur de canal (206) est configuré de manière à déterminer si la deuxième séquence d'unités d'information codée par canal ($y_{24}$) peut être décodée correctement et à fournir la deuxième séquence d'unités d'information décodée ($\hat{u}24$) comprenant des informations de redondance pour reconstruire correctement un signal ($u_2$) envoyé par la deuxième source de données (MS2).

8. Dispositif de relais de communication (R) selon la revendication 7, dans lequel le codeur de réseau (208) est configuré de manière à recevoir un signal de confirmation du bloc récepteur de données (BS) et dans lequel le codeur de réseau (208) est configuré de manière à transmettre, en réponse au signal de confirmation, d'autres informations codées par réseau/canal.

9. Système de relais de communication, comprenant:

   un premier appareil de relais de communication (R1) selon l'une des revendications 1 à 8, dans lequel le premier décodeur de canal du premier dispositif de relais de communication (R1) est configuré de manière à recevoir la première séquence d'unités d'information codée par canal de la première source de données (MS1), dans lequel le deuxième décodeur de canal du premier dispositif de relais de communication (R1) est configuré de manière à recevoir la deuxième séquence d'unités d'information codée par canal de la deuxième source de données (MS2) et dans lequel le codeur de réseau du premier dispositif de relais de communication (R1) est configuré de manière à fournir une première séquence d'unités d'information codée par réseau/canal et à transmettre la première séquence d'unités d'information codée par réseau au bloc récepteur de données (BS); et

un deuxième dispositif de relais de communication (R2) selon l'une des revendications 1 à 8, dans lequel le premier décodeur de canal du deuxième dispositif de relais de communication (R2) est configuré de manière à recevoir une troisième ou la troisième séquence d'unités d'information codée par canal d'une troisième source de données respective (MS3), dans lequel le deuxième décodeur de canal du deuxième dispositif de relais de communication (R2) est configuré de manière à recevoir la deuxième séquence d'unités d'information codée par canal de la deuxième source de données (MS2) et dans lequel le codeur de réseau du deuxième dispositif de relais de communication (R2) est configuré de manière à fournir une deuxième séquence d'unités d'information codée par réseau/canal et à transmettre la deuxième séquence d'unités d'information codée par réseau/canal au bloc récepteur de données (BS).

**10.** Procédé pour fournir une séquence d'unités d'information codée par réseau/canal ($x_4$), comprenant les étapes consistant à:

recevoir une première séquence d'unités d'information codée par canal ($y_{14}$) d'une première source de données (MS1) via un premier canal sans fil (200) et décoder la première séquence d'unités d'information codée par canal ($y_{14}$) pour obtenir une première séquence d'unités d'information décodée ($\hat{u}_{14}$);
recevoir une deuxième séquence d'unités d'information codée par canal ($y_{24}$) d'une deuxième source de données (MS2) via un deuxième canal sans fil (202) et décoder la deuxième séquence d'unités d'information codée par canal ($y_{24}$) pour obtenir une deuxième séquence d'unités d'information décodée ($\hat{u}_{24}$), les premier et deuxième canaux sans fil (200, 202) étant différents l'un de l'autre;
combiner et coder ensemble par réseau/canal les informations des première et deuxième séquences d'unités d'information décodées ($\hat{u}_{14}$, $\hat{u}_{24}$) pour obtenir la séquence d'unités d'information codée par réseau/canal ($x_4$); et
transmettre sans fil la séquence d'unités d'information codée par réseau/canal ($x_4$) à un bloc récepteur de données (BS).

**11.** Récepteur de communication (BS) pour fournir une première et une deuxième séquence de sortie de décodeur de canal ($\hat{u}_{13}$, $\hat{u}_{23}$), le récepteur de communication (BS) comprenant:

un décodeur de réseau (402) configuré de manière à recevoir une séquence d'unités d'information codée par réseau/canal ($y_{43}$), la séquence d'unités d'information codée par réseau/canal ($y_{43}$) comprenant les informations d'une première et d'une deuxième source de données (MS1, MS2) qui ont été transmises sur respectivement un premier et un deuxième canal sans fil, dans lequel le décodeur de réseau (402) est configuré de manière à décoder la séquence d'unités d'information codée par réseau/canal ($y_{43}$) pour obtenir des séquences de décodeur de réseau (406, 407);
un premier décodeur de canal (400) configuré de manière à recevoir une première séquence d'information codée par canal ($y_{13}$) d'une première source de données (MS1) via un premier canal (100) et à décoder la première séquence d'unités d'information codée par canal ($y_{13}$) au moyen de la séquence de décodeur de réseau (406) pour obtenir la première séquence de sortie de décodeur de canal($\hat{u}_{13}$); et
un deuxième décodeur de canal (404) configuré de manière à recevoir une deuxième séquence d'unités d'information codée par canal ($y_{23}$) d'une deuxième source de données (MS2) via un deuxième canal (110), les premier et deuxième canaux (100, 110) étant différents l'un de l'autre, dans lequel le deuxième décodeur de canal (404) est, par ailleurs, configuré de manière à décoder la deuxième séquence d'unités d'information codée par canal ($y_{23}$) au moyen de la séquence de décodeur de réseau (407) pour obtenir la deuxième séquence de sortie de décodeur de canal ($\hat{u}_{23}$).

**12.** Récepteur de communication (BS) selon la revendication 11, dans lequel le premier décodeur de canal (400) est configuré de manière à fournir une première séquence d'informations de décodeur douces (410), dans lequel le deuxième décodeur de canal (404) est configuré de manière à fournir une deuxième séquence d'informations de décodeur douces (408), et dans lequel le décodeur de réseau (402) est configuré de manière à recevoir les première ou deuxième séquences d'informations de décodeur douces (408, 410) et à décoder la séquence d'unités d'information codée par réseau/canal ($y_{43}$) en réaction aux première ou deuxième séquences d'informations de décodeur douces (408, 410).

**13.** Récepteur de communication (BS) selon la revendication 11 ou 12, dans lequel le premier décodeur de canal (400) et le deuxième décodeur de canal (404) sont configurés de manière à surveiller des canaux mobiles sans fil (100, 110) et dans lequel les sources de données (MS1, MS2) sont des sources de données mobiles.

**14.** Récepteur de communication (BS) selon l'une des revendications 11 à 13, dans lequel le décodeur de réseau (402) est configuré de manière à effectuer un décodage de réseau/canal au moyen d'un code de bloc linéaire ou d'un code convolutionnel.

**15.** Récepteur de communication (BS) selon la revendication 14, dans lequel le code de bloc linéaire est un code de contrôle de parité de faible densité.

**16.** Récepteur de communication (BS) selon l'une des revendications 11 à 15, dans lequel le décodeur de réseau (402) est configuré de manière à recevoir la séquence d'unités d'information codée par réseau/canal ($y_{43}$) présentant un premier taux de code et dans lequel le codeur de réseau (402) est configuré de manière à fournir une autre séquence d'unités d'information codée par réseau/canal ($y_{43}$) présentant un deuxième taux de code, les premier et deuxième taux de code étant différents l'un de l'autre.

**17.** Récepteur de communication (BS) selon l'une des revendications 11 à 16, dans lequel le décodeur de réseau (406) est configuré de manière à décoder par réseau la séquence d'unités d'information codée par réseau/canal ($y_{43}$) comprenant les informations d'une première, d'une deuxième et d'une troisième source de données (MS1, MS2, MS3), dans lequel le décodeur de réseau (402) est configuré de manière à décoder la séquence d'unités d'information codée par réseau/canal ($y_{43}$) pour obtenir des séquences de décodeur de réseau (406, 407, 409), le récepteur de communication (BS) comprenant par ailleurs:

un troisième décodeur de canal configuré de manière à surveiller un troisième canal, à recevoir une troisième séquence d'unités d'information codée par canal d'une troisième source de données (MS3) via un troisième canal et à décoder la troisième séquence d'unités d'information codée par canal au moyen de la séquence de décodeur de réseau (409) pour obtenir une troisième séquence de sortie de décodeur de canal, les premier, deuxième et troisième canaux étant différents l'un de l'autre.

**18.** Récepteur de communication (BS) selon l'une des revendications 11 à 17, dans lequel le premier décodeur de canal (400), le deuxième décodeur de canal (404) et le décodeur de réseau (402) sont configurés de manière à déterminer si les séquences d'unités d'information codées ($y_3$, $y_{23}$, $y_{43}$) peuvent être décodées correctement et à envoyer un signal de confirmation négatif à un dispositif de relais de communication (R) dans le cas où les séquences d'unités d'information codées ($y_{13}$, $y_{23}$, $y_{43}$) ne peuvent pas être décodées correctement, ou dans lequel le deuxième décodeur de canal (404) est configuré de manière à déterminer si la première séquence d'unités d'information codée par canal ($y_{23}$) peut être décodée correctement et à envoyer un signal de confirmation au dispositif de relais de communication (R) dans le cas où la deuxième séquence d'unités d'information codée par canal ($y_{23}$) ne peut pas être décodée correctement.

**19.** Récepteur de communication (BS) selon la revendication 17, dans lequel le décodeur de réseau (402) est configuré de manière à décoder, en réponse au signal de confirmation envoyé au dispositif de relais de communication (R), les informations de redondance de la séquence d'unités d'information codée par réseau/canal ($y_{43}$) pour le premier décodeur de canal (400), pour reconstruire correctement le signal ($u_1$) envoyé par la première source de données (MS1) ou dans lequel le décodeur de réseau (402) est configuré de manière à décoder, en réponse au signal de confirmation, les informations de redondance de la séquence d'unités d'information codée par réseau/canal ($y_{43}$) pour le deuxième décodeur de canal (402), pour reconstruire correctement le signal ($u_1$) envoyé par la deuxième source de données (MS2).

**20.** Système de récepteur de communication, comprenant:

un récepteur de communication (BS) selon l'une des revendications 11 à 19; et
un dispositif de relais de communication (R) selon l'une des revendications 1 à 8 ou un système de relais de communication selon la revendication 9.

**21.** Procédé pour fournir une première et une deuxième séquence de sortie de décodeur de canal ($\hat{u}_{13}$, $\hat{u}_{23}$), le procédé étant prévu pour recevoir une séquence codée par réseau/canal sortie conformément à un procédé selon la revendication 10, le procédé pour fournir comprenant les étapes consistant à:

recevoir une séquence d'unités d'information codée par réseau/canal ($y_{43}$) par un décodeur de réseau (402), la séquence d'unités d'information codée par réseau ($y_{43}$) comprenant les informations d'une première et d'une deuxième source de données (MS1, MS2);
décoder la séquence d'unités d'information codée par réseau/canal ($y_{43}$) pour obtenir des séquences de décodeur de réseau (406, 409);

recevoir une première séquence d'unités d'information codée par canal ($y_{13}$) de ladite première source de données (MS1) par un premier décodeur de canal (400) via un premier canal (100);

décoder la première séquence d'unités d'information codée par canal ($y_{13}$) par le premier décodeur de canal (400) au moyen de la séquence de décodeur de réseau (406) pour obtenir la première séquence de sortie de décodeur de canal ($\hat{u}_{13}$);

recevoir une deuxième séquence d'unités d'information codée par canal ($y_{23}$) de la deuxième source de données (MS2) par un deuxième décodeur de canal (404) via un deuxième canal (110), les premier et deuxième canaux (100, 110) étant différents l'un de l'autre;

décoder la deuxième séquence d'unités d'information codée par canal ($y_{23}$) par le deuxième décodeur de canal (404) au moyen de la séquence de décodeur de réseau pour obtenir la deuxième séquence de sortie de décodeur de canal ($\hat{u}_{23}$).

**22.** Procédé selon la revendication 21, comprenant, par ailleurs, les étapes consistant à:

fournir une première séquence d'informations de décodeur douces (410) par le premier décodeur de canal (400);

fournir une deuxième séquence d'informations de décodeur douces (408) par le deuxième décodeur de canal (404);

décoder la séquence d'unités d'information codée par réseau/canal ($y_{43}$) dans le décodeur de réseau (402) au moyen de la première séquence d'informations de décodeur douces (410) ou la deuxième séquence d'informations de décodeur douces (408) pour fournir une première séquence de décodeur de réseau (406) et une deuxième séquence de décodeur de réseau (407);

fournir une autre première séquence d'informations de décodeur douces (410) et une autre première séquence de sortie de décodeur de canal ($\hat{u}_{13}$) par le premier décodeur de canal (400) au moyen de la première séquence de décodeur de réseau (406);

fournir une autre deuxième séquence d'informations de décodeur douces (408) et une autre deuxième séquence de sortie de décodeur de canal ($\hat{u}_{23}$) par le deuxième décodeur de canal (404) au moyen de la deuxième séquence de décodeur de réseau (407);

décoder la séquence d'unités d'information codée par réseau/canal ($y_{43}$) dans le décodeur de réseau (402) au moyen de l'autre première séquence d'informations de décodeur douces (410) ou l'autre deuxième séquence d'informations de décodeur douces (408) pour fournir une première séquence de décodeur de réseau améliorée (406) et une deuxième séquence de décodeur de réseau améliorée (407);

fournir une première séquence additionnelle d'informations de décodeur douces (410) et une première séquence additionnelle de sortie de décodeur de canal ($\hat{u}_{13}$) par le premier décodeur de canal (400) au moyen de la première séquence de décodeur de réseau améliorée (406);

fournir une deuxième séquence additionnelle d'informations de décodeur douces (408) et une deuxième séquence additionnelle de sortie de décodeur de canal ($\hat{u}_{23}$) par le deuxième décodeur de canal (404) au moyen de la deuxième séquence de décodeur de réseau améliorée (407).

**23.** Programme d'ordinateur présentant un code de programme destiné à effectuer les procédés selon l'une des revendications 10 à 21 lorsque le programme est exécuté sur un ordinateur.

FIG. 1

FIG. 2

MS1
→
N

(N-K)d$_C$

Π

N-K

R
→
N$_R$

NR·d$_V$

Π

N$_R$

MS2
→
N

(N-K)d$_C$

Π

N-K

(a)

MS1
→
N

(N-K)d$_C$

Π

N-K

R
→
N$_R$

N$_R$/2·d$_V$

Π

N$_R$/2·d$_V$

Π

N$_R$

MS2
→
N

(N-K)d$_C$

Π

N-K

(b)

MS1
→
N

(N-K)d$_C$

Π

N-K

MS2
→
N

(N-K)d$_C$

Π

N-K

(c)

FIG. 3

400

BS

$y_{13}$ → | Channel Decoder 1 | → $\hat{u}_{13}$

410

406

$y_{43}$ → | Network Decoder | 402

408

407

$y_{23}$ → | Channel Decoder 2 | → $\hat{u}_{23}$

404

# FIG. 4

| System | K | N | $N_R$ | R | $R_R$ | $R_S$ |
|---|---|---|---|---|---|---|
| Relay, network cod. | 1500 | 2000 | 2000 | 0.75 | 1.5 | 0.5 |
| Relay, no network cod. | 1500 | 2000 | 2000 | 0.75 | 1.5 | 0.5 |
| No relay | 1500 | 3000 | 0 | 0.5 | $\infty$ | 0.5 |

# FIG. 5

FIG. 6

FIG. 7

(a)

(b)

# FIG. 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2005027396 A1

### Non-patent literature cited in the description

- **B ZHAO ; M. VALENTI.** Distributed Turbo Coded Diversity for the Rayleigh Channel. *Electronic Letters,* 2003, vol. 39, 786-787
- **B. ZHAO ; M. VALENTI.** Practical Relay Networks: A Generalization of Hybrid-ARQ. *IEEE Journal on Selected Areas in Communications,* January 2005, vol. 23 (1), 7-18
- **T. J. RICHARDSON ; M. A. SHOKROLLAHI ; R. L. URBANKE.** Design of Capacity-Approaching irregular low density parity-check codes. *IEEE Transactions on Information Theory,* February 2001, vol. 47 (2), 619-637